# EUROPEAN PATENT APPLICATION

(11) **EP 3 971 318 A1**
(43) Date of publication of application: **23.03.2022**
(21) Application number: 21191939.4
(22) Date of filing: 18.08.2021
(51) Int. Cl.: C23C 14/00, C23C 14/06, C23C 14/34, H01L 41/316, H03H 3/02, H03H 9/02

(54) **DEPOSITION METHOD**

(30) Priority: 16.09.2020 GB 202014592
(71) Applicant: SPTS Technologies Limited, Newport Gwent NP18 2TA (GB)
(72) Inventor: Haymore, Scott, Newport (GB); Thomas, Adrian, Newport (GB); Wilby, Tony, Newport (GB)
(74) Representative: Wynne-Jones IP Limited

(57) **Abstract**

According to the present invention there is provided a method of sputter depositing from a target an additive-containing aluminium nitride film containing an additive element selected from: scandium (Sc), yttrium (Y), titanium (Ti), chromium (Cr), magnesium (Mg) and hafnium (Hf), the method comprising the steps of:
providing a semiconductor substrate having a metallic layer thereon in a chamber; and
depositing the additive-containing aluminium nitride film onto the metallic layer by pulsed DC reactive sputtering of the target;
wherein the step of depositing the additive-containing aluminium nitride film comprises introducing a gaseous mixture comprising nitrogen gas and an inert gas into the chamber at a flow rate in sccm, in which the flow rate of the gaseous mixture in sccm comprises a nitrogen gas flow rate in sccm, and in which the nitrogen gas flow rate in sccm is less than or equal to about 50% of the flow rate of the gaseous mixture in sccm and also is sufficient to fully poison the target.

## Description

This invention relates to a method of sputter depositing an additive-containing aluminium nitride film. In particular, this invention relates to sputter depositing from a target an additive-containing aluminium nitride film containing an additive element selected from: scandium, yttrium, titanium, chromium, magnesium and hafnium onto a metallic layer of a substrate.

Bulk acoustic wave (BAW) devices are used in cell phone and other wireless applications to allow a specific radio frequency (RF) to be received and/or transmitted. BAW devices utilise the piezoelectric effect to generate a mechanical resonance from an electric input; or to generate an electrical output from a mechanical resonance.

Known BAW devices typically comprise several layers that are deposited and patterned on a silicon (Si) substrate. For example, a BAW device can comprise two metallic electrodes with a piezoelectric dielectric layer (e.g. AIN or AIScN) in between.

As wireless applications have moved towards using higher frequency bands, the piezoelectric layers have become thinner. There is a desire to improve (i.e. increase) the piezoelectric coupling properties of the thinner films required for use at higher frequency bands. Additive-containing aluminium nitrides (e.g. Al₁₀₀₋ₓScₓN) thin films are promising candidates to exhibit excellent piezoelectric coupling.

To improve the coupling properties of these materials, there is a desire to increase the dopant level of the additive element (e.g. to increase the Sc content). For example, when Al₁₀₀₋ₓScₓN is used in 4G applications, the Sc content is typically about 6-12 at.% (i.e. x is typically about 6-12). However, it is expected that even higher levels of the additive element (e.g. x = 15-20) will be needed for 5G and future generations of network applications. There is accordingly a desire to develop a method for depositing additive-containing aluminium nitride films, such as Al₁₀₀₋ₓScₓN, with a higher content of the additive element (e.g. >12 at.%, and preferably ≥15 at.%).

Additive-containing aluminium nitrides may also have applications in piezoelectric microelectromechanical systems (piezoMEMS) devices, such as microphones, Si timing devices, energy harvesters and piezoelectric micromachined ultrasonic transducer (pMUTs). It is expected that these applications could benefit from a high additive-element (e.g. Sc) content in the films to provide improved properties, such as an improved piezoelectric response.

Physical vapour deposition (PVD) can be used to sputter deposit additive-containing aluminium nitride films onto a substrate. However, these known methods typically lead to the formation of unwanted crystallite defects in the resultant film. When viewed by SEM, for example, these crystallite defects appear as triangular-shaped abnormal or misaligned grains. These defects become more prevalent at higher concentrations of the additive element. These crystallite defects act as piezoelectric 'dead zones' with poor piezoelectric properties, which overall reduces the piezoelectric coupling ability of the film. There is a desire to develop an improved method of depositing an additive-containing aluminium nitride film which has a reduced level of defects in the film, in particular where the film comprises a high additive element concentration (e.g. about x >12 and preferably ≥15).

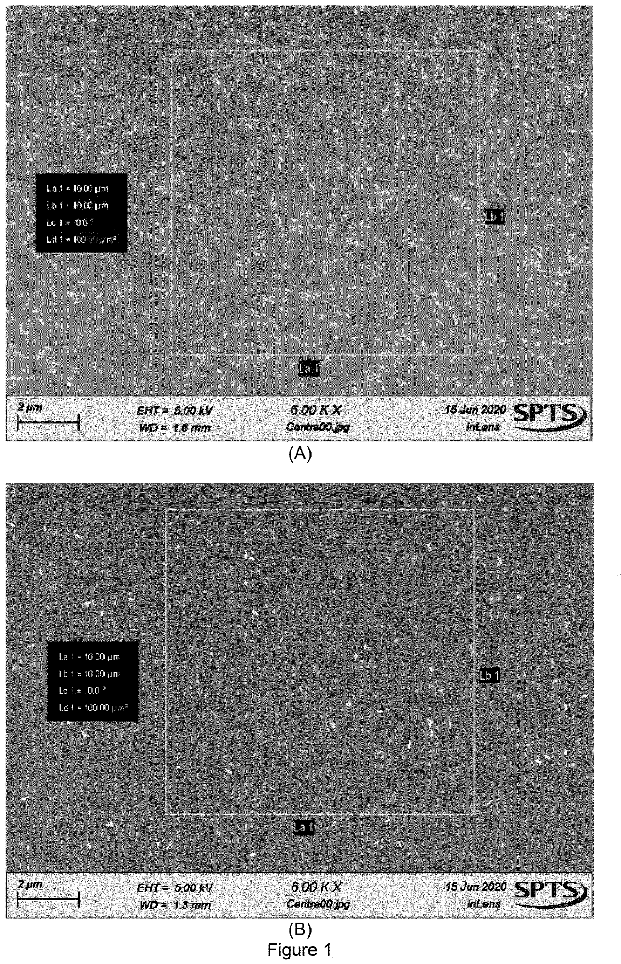

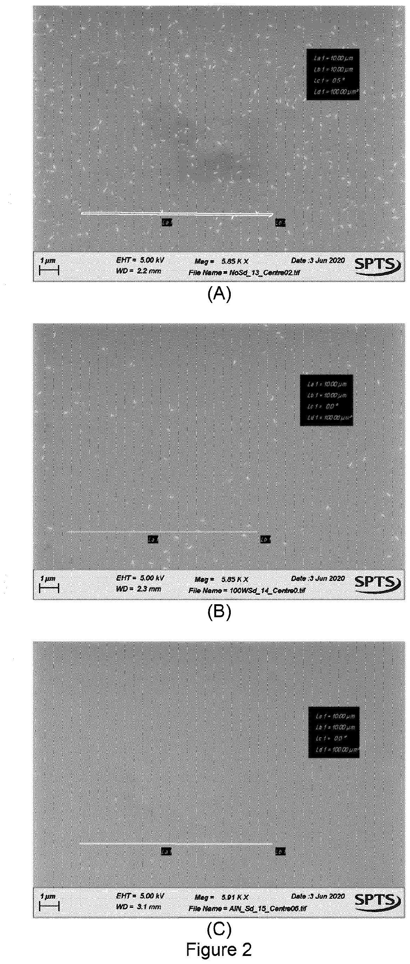

When depositing additive-containing aluminium nitride films (e.g. Al₁₀₀₋ₓScₓN films) on a silicon substrate, pre-treating the silicon surface can help to reduce the defect density (as determined using SEM images of the film and analysis). Suitable pre-treatments can include a pre-etch, a pre-clean, or depositing a seed layer prior to the bulk deposition. Figure 1 shows Al₁₀₀₋ₓScₓN films deposited on a silicon substrate using a known method (a) without a pre-etch prior to the deposition step, and (b) with a pre-etch prior to the deposition step. The white squares in Figure 1 correspond to a 10 µm × 10 µm area, which can be used to determine the defect density in a 100 µm² area. Figure 2 shows Al₁₀₀₋ₓScₓN films deposited on a silicon substrate using a known method: (a) without a seed layer, (b) with a compressive AIScN seed layer, and (c) with an AIN seed layer. Figures 2(a)-(c) show how using a seed layer can improve (i.e. reduce) defect density when depositing an AIScN film on a silicon substrate. However, such pre-treatments are not known to be as effective at reducing the defect density on metallic surfaces, such as electrode structures. It is desirable to develop a method to reduce the defect density of additive-containing aluminium nitride films that are deposited on metallic surfaces (e.g. a silicon substrate comprising a metallic coating).

The present invention, in at least some of its embodiments, seeks to address at least some of the above described problems, desires and needs. In particular, the present invention, in at least some embodiments, seeks to reduce the prevalence of defects (i.e. reduce the defect density) in additive-containing aluminium nitride films. In particular, to reduce the defect density in additive-containing aluminium nitride films containing a high concentration of additive element (e.g. about >12% and preferably ≥15 at.%).

According to a first aspect of the invention there is provided a method of sputter depositing from a target an additive-containing aluminium nitride film containing an additive element selected from: scandium (Sc), yttrium (Y), titanium (Ti), chromium (Cr), magnesium (Mg) and hafnium (Hf), the method comprising the steps of:
providing a semiconductor substrate having a metallic layer thereon in a chamber; and
depositing the additive-containing aluminium nitride film onto the metallic layer by pulsed DC reactive sputtering of the target;
wherein the step of depositing the additive-containing aluminium nitride film comprises introducing a gaseous mixture comprising nitrogen gas and an inert gas into the chamber at a flow rate in sccm, in which the flow rate of the gaseous mixture in sccm comprises a nitrogen gas flow rate in sccm, and in which the nitrogen gas flow rate in sccm is less than or equal to about 50% of the flow rate of the gaseous mixture in sccm and also is sufficient to fully poison the target.

Using a nitrogen gas flow rate in sccm that is less than or equal to about 50% of the flow rate of the gaseous mixture in sccm and also sufficient to fully poison the target (i.e. present in a proportion at or above a poison threshold percentage) reduces the defect density of additive-containing aluminium nitride films that are deposited on the metallic layer of the substrate. This can lead to improved films exhibiting improved piezoelectric properties, such as improved piezoelectric coupling.

The poison threshold percentage is the minimum percentage at which the nitrogen gas flow rate in sccm as a percentage of the flow rate of the gaseous mixture in sccm is sufficient to fully poison the target. The poison threshold percentage corresponds to a transition point at which the pulsed DC reactive sputtering process transitions between operating in a "metallic sputtering mode" and operating in a "poisoned sputtering mode".

Using a flow rate of the gaseous mixture (in sccm) which comprises a flow of nitrogen gas (in sccm) in a proportion sufficient to fully poison the target (i.e. at or above the poison threshold percentage) causes the pulsed DC reactive sputtering step to operate in the poisoned sputtering mode (also known as a "compound mode" or "reactive mode"). Without wishing to be bound by any theory or conjecture, it is believed that when the proportion of nitrogen gas is at or above the poison threshold percentage, the flow of nitrogen gas forms a nitride layer on the surface of the target so as to fully poison the target. The percentage of nitrogen gas that is sufficient to fully poison the target (i.e. the poison threshold percentage) is typically dependent upon the process parameters. The percentage of nitrogen gas that is sufficient to fully poison the target (i.e. the poison threshold percentage) can be determined by measuring the target voltage (at a constant power) as a function of the percentage of nitrogen gas (in sccm) in the total flow rate of the gaseous mixture (in sccm) - a step change in the target voltage (at constant power) is indicative of the poison threshold percentage. For example, the magnitude of the target voltage above the poison threshold percentage is lower than the target voltage below the poison threshold percentage when depositing Al₁₀₀₋ₓScₓN (for a fixed power). Above the poison threshold percentage, the target voltage typically remains substantially constant. From this, and from further explanation provided below, it will be apparent to the skilled reader that the poison threshold percentage, and hence the minimum nitrogen gas flow rate that is sufficient to fully poison the target, can be readily determined without undue burden.

The additive element can be scandium (Sc) or yttrium (Y). Preferably, the additive element is scandium (Sc). The additive-containing aluminium nitride film can be a ternary alloy.

The additive-containing aluminium nitride can correspond to Al₁₀₀₋ₓXₓN, where X is the additive-element. For example, the additive-containing aluminium nitride can be Al₁₀₀₋ₓScₓN or Al₁₀₀₋ₓYₓN. It is understood that when the composition is expressed in the form Al₁₀₀₋ₓXₓN, the values '100-x' and 'x' are expressed as atomic percentages of the metallic content of the film, and 'x' as a percentage can be equated to '0.0x' in stoichiometric chemical terms. The additive element, as an atomic percentage of the aluminium and additive element content of the additive-containing aluminium nitride film, can be present in an amount in the range of 0.5 at.% to 40 at%, optionally in the range 8 at.% to 40 at.%, optionally in the range 10 at.% to 40 at.%, optionally in the range 12 at.% to 35 at.%, optionally in the range 15 at.% to 30 at.%, or optionally in the range 20 at.% to 25 at.%. That is, x can be in the range of 0.5-40, optionally in the range of 8-40, optionally in the range of 10-40, optionally in the range of 12-35, optionally in the range of 15-30, or optionally in the range of 20-25. The additive element can be present in an amount of >8 at.%, >10 at.%, >12 at.%, >15 at.%, >20 at.%, >25 at.%, or about 30 at.%. The additive element can be present in an amount less than or equal to 40 at.%. The additive element can be present in any combination of the upper and lower limits provided above. Methods of the present invention can be particularly effective for depositing additive-containing aluminium nitride films having a high concentration of additive element (e.g. above 12 at.%, preferably ≥15 at.%), whilst improving or maintaining acceptable levels of defect density, crystallinity and texture. At these concentrations, the compound can be considered to be an alloy rather than a doped AIN. The elemental composition of the additive-containing aluminium nitride film, including the amount of additive element present in the film, can be determined using energy dispersive X-ray (EDAX) analysis. For example, the present invention can be used to deposit an additive-containing aluminium nitride film having a defect density (as determined using analysis of SEM images) of less than about 30 defects per 100 µm², preferably less than about 20 defects per 100 µm², wherein the additive element (as a percentage of the metallic content of the film) is present in an amount of >12 at.%, optionally ≥15 at.%, optionally ≥20 at.%, optionally ≥25 at.%, or optionally about 30 at.%.

The nitrogen gas flow rate in sccm can be less than about 45%, optionally less than about 40%, optionally less than about 35%, and optionally about 30%, of the flow rate of the gaseous mixture in sccm.

The nitrogen gas flow rate in sccm can be greater than the poison threshold percentage and greater than about 15%, optionally ≥20%, optionally ≥25%, or optionally ≥30%, of the flow rate of the gaseous mixture in sccm.

The nitrogen gas flow rate in sccm used during the step of depositing the additive-containing aluminium nitride film can be in the range of 25 to 250 sccm, optionally 30 to 200 sccm, optionally 40 to 150 sccm, optionally 45 to 100 sccm, or optionally about 50 sccm.

The flow rate of the gaseous mixture in sccm further comprises an inert gas flow rate in sccm. The inert gas flow rate in sccm used during the step of depositing the additive-containing aluminium nitride film can be in the range of 25 to 250 sccm, optionally 30 to 200 sccm, optionally 40 to 150 sccm, optionally 45 to 100 sccm, or optionally 50 to 90 sccm.

The gaseous mixture can consist of or consist essentially of nitrogen gas and the inert gas. The flow rate can consist of or consist essentially of the flow of nitrogen gas and the flow of the inert gas.

The inert gas can be argon, krypton, xenon or a mixture thereof. Preferably, the inert gas is or consists essentially of argon.

The chamber can have a pressure in the range 1-10 mTorr, optionally about 2-6 mTorr, or optionally about 4 mTorr during the step of depositing the additive-containing aluminium nitride film.

The additive-containing aluminium nitride film can have a thickness of about 2 µm or less, optionally about 1.5 µm or less, optionally about 1 µm or less, or optionally about 0.5 µm or less.

The additive-containing aluminium nitride film can have a thickness of about 0.2 µm or greater, optionally about 0.3 µm or greater, or optionally about 0.5 µm or greater.

The step of depositing the additive-containing aluminium nitride film can comprise applying an electrical bias power to the substrate. The electrical bias power can be an RF electrical bias power.

The substrate can have a temperature of about 150 to 300 °C, optionally about 200 °C during the step of depositing the additive-containing aluminium nitride film.

The semiconductor substrate can be a silicon wafer.

The metallic layer can be selected from: tungsten (W), molybdenum (Mo), aluminium (Al), platinum (Pt), and ruthenium (Ru). The metallic layer can be an electrode structure. The metallic layer can be a tungsten underlayer.

The method can optionally further comprise a step of etching the metallic layer prior to the step of depositing the additive-containing aluminium nitride film.

The method can optionally further comprise a step of depositing a seed layer onto the metallic layer prior to the step of depositing the additive-containing aluminium nitride film so that the additive-containing aluminium nitride film is deposited onto the seed layer. By way of example only, the seed layer can be an aluminium nitride (AIN) seed layer or an additive-containing aluminium nitride seed layer, such as AIScN.

Pre-treating the metallic layer prior to the step of depositing the additive-containing aluminium nitride film can further help to reduce the defect density, whilst helping to maintain adequate film texture and crystallinity.

According to a second aspect of the invention there is an additive-containing aluminium nitride film on a metallic layer of a semiconductor substrate produced using the method according to the first aspect.

Whilst the invention has been described above, it extends to any combination of the features set out above, or in the following description, drawings and claims.

For example, any features disclosed in relation to one aspect of the invention may be combined with any features of any of the other aspects of the invention.

Embodiments of the invention will now be described, by way of example only, with reference to the accompanying drawings, in which:
Figure 1 is an SEM image of an Al₁₀₀₋ₓScₓN film deposited on a silicon substrate (a) without a pre-etch; and (b) with a pre-etch;
Figure 2 is an SEM image of an Al₁₀₀₋ₓScₓN film deposited on a silicon substrate (a) without a seed layer; (b) with a compressive AlScN seed layer; and (c) with a AlN seed layer;
Figure 3 is an SEM image of an Al₁₀₀₋ₓScₓN film deposited where the percentage of nitrogen gas in the gaseous mixture was 100%;
Figure 4 is an SEM image of an Al₁₀₀₋ₓScₓN film deposited where the percentage of nitrogen gas in the gaseous mixture was 83%;
Figure 5 is an SEM image of an Al₁₀₀₋ₓScₓN film deposited where the percentage of nitrogen gas in the gaseous mixture was 67%;
Figure 6 is an SEM image of an Al₁₀₀₋ₓScₓN film deposited where the percentage of nitrogen gas in the gaseous mixture was 36%; and
Figure 7 shows plots of target voltage (at constant power) and defect density (per 100 µm²) as a function of percentage nitrogen gas in the gaseous mixture.

For the avoidance of doubt, when reference is made to 'open-ended' terms such as 'comprising', 'comprise' and 'comprises', the invention is understood to relate also to embodiments in which the open-ended terms are replaced by 'closed' terms such as 'consisting of' and 'consisting essentially of'.

The inventors have discovered an advantageous process for sputter depositing an additive-containing aluminium nitride film (e.g. Al₁₀₀₋ₓXₓN) onto a metallic layer of a substrate. The method can help to reduce crystallite defects in the additive-containing aluminium nitride film. The methods of the present invention have particular application when the additive element (X) is present at high concentrations (e.g. x >12, preferably x ≥15). The additive-containing aluminium nitride film contains an additive element. The additive element can be scandium (Sc), yttrium (Y), titanium (Ti), chromium (Cr), magnesium (Mg), or hafnium (Hf). The results presented below are in relation to aluminium scandium nitride (Al₁₀₀₋ₓScₓN) films. However, the method can be readily applied to any of the additive elements mentioned above, i.e. Sc, Y, Ti, Cr, Mg and Hf. For example, the method is also applicable to deposit aluminium yttrium nitride (Al₁₀₀₋ₓYₓN) films.

General details concerning apparatus which can be used or readily adapted for use in the present invention are described in the applicant's European Patent applications EP2871259, EP3153603, the entire contents of which are hereby incorporated by reference.

A SPTS Sigma fxP AIN PVD tool, which is commercially available from SPTS Technologies Limited of Newport, South Wales, UK, was used to deposit the additive-containing aluminium nitride films of the following examples. The apparatus comprises a substrate support disposed in a chamber. During a deposition process, a semiconductor substrate having a metallic layer thereon is positioned on the substrate support. For example, the substrate can be a silicon wafer with a metallic coating thereon. The metallic layer has a metallic surface. The metallic layer can be an electrode structure, for example an electrode of a piezoelectric device, such as a bulk acoustic wave (BAW) device. By way of example only, the metallic layer can be made from tungsten (W), molybdenum (Mo), aluminium (Al), platinum (Pt) or ruthenium (Ru).

The apparatus further comprises a target disposed within the chamber. The target is a composite target formed from aluminium and the additive element. The use of multiple targets is possible but is likely to be less economically attractive. Pulsed DC sputtering comprises applying pulses of DC power to the target (cathode) during the deposition process.

The method includes introducing a gaseous mixture into the chamber at a flow rate, and subsequently using pulsed DC reactive sputtering to reactively sputter deposit material from the target onto the metallic surface of the metallic layer.

The gaseous mixture comprises nitrogen gas (N₂) and an inert gas. The inert gas can be argon, krypton or xenon, or any mixture thereof. Typically, the inert gas is argon. The inert gas acts as a co-sputtering non-reactive species and can improve plasma stability.

The proportion of N₂ gas in the gaseous mixture can influence the deposition process. Without wishing to be bound by any theory or conjecture, it is believed that at a very low N₂ gas concentration (or in the absence of N₂ gas), the pulsed DC sputter process will run in a "metallic mode". In the metallic mode, the target material will be sputtered with little or no reaction with N₂ gas. As the proportion of N₂ gas increases, some nitrogen is incorporated into the surface of the target, and the target begins to be poisoned. When the proportion of nitrogen in the gas mixture is sufficiently high, a nitride layer will form on the target, the target will be fully poisoned and the sputter process will operate in a "poisoned mode" (also referred to as a "compound mode" or "reactive mode"). This occurs when the surface of the target is fully converted to a nitride, and the target is fully poisoned.

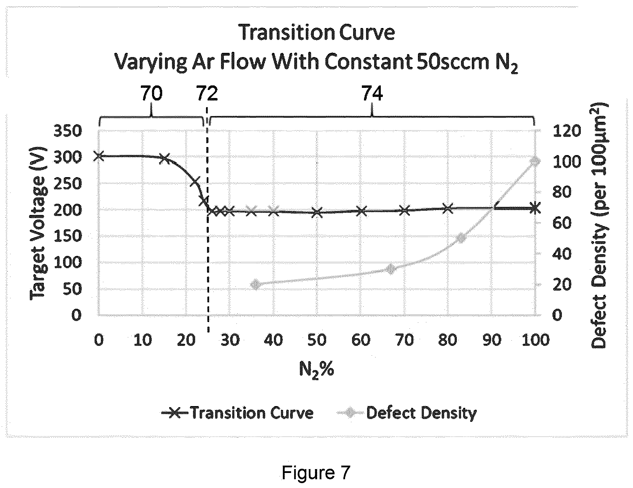

The transition between the "metallic mode" and the "poisoned mode" occurs at a "transition point" (or "poison threshold percentage" of nitrogen gas), which corresponds to the point at which the proportion of nitrogen gas in the gas mixture is sufficiently high to fully poison the target (i.e. to cause the sputter deposition to operate in the "poisoned mode"). The poison threshold percentage for a particular set of process conditions can be determined by measuring the target voltage (at constant target power) as a function of nitrogen gas percentage, as illustrated in Figure 7 (as discussed in more detail below).

The overwhelming received wisdom in the art is to operate pulsed DC reactive sputtering processes in a "poisoned mode" far from the transition point (i.e. using a very high percentage of N₂ gas in the reactive gas mixture). For example, in one known process, the ratio of flow rates of N₂ gas to Ar gas (in sccm) is 50:10 (i.e. 83% N₂ gas).

However, contrary to this received wisdom in the art, the present inventors have unexpectedly found that using a N₂ flow that is ≤50% of the total flow rate of the gaseous mixture (whilst still operating in the "poisoned mode") can reduce the defect density of an additive-containing aluminium nitride film that is deposited onto a metallic surface by pulsed DC reactive sputtering. These effects are particularly beneficial at high concentrations of additive element (e.g. >12 at.%, preferably ≥15 at.%), where defects are typically more prevalent.

In one example, Al₁₀₀₋ₓScₓN films (x = 30) were deposited by pulsed DC reactive sputtering onto a textured tungsten (W) underlayer. The gaseous mixture comprised N₂ gas and argon. The proportion of N₂ gas in the gaseous mixture was varied whilst all other process parameters, such as chamber pressure and target power, were kept constant. Exemplary process parameters used in this example are shown in Table 1.

**Table 1**

| | Al₁₀₀₋ₓScₓN |
|---|---|
| Pulse DC power (kW) | 6 |
| Pulse frequency (kHz) | 100 |
| Pulse width (µs) | 4 |
| Ar flow rate (sccm) | 0-90 |
| N₂ flow rate (sccm) | 50 |
| Platen RF bias power (W) | Adjusted for required stress |
| Platen temperature (°C) | 200 |

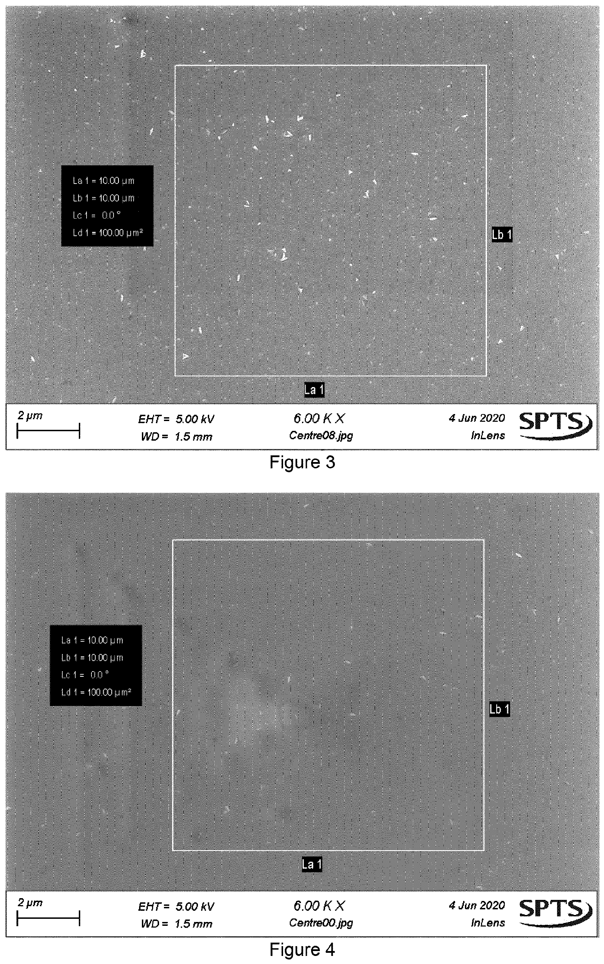

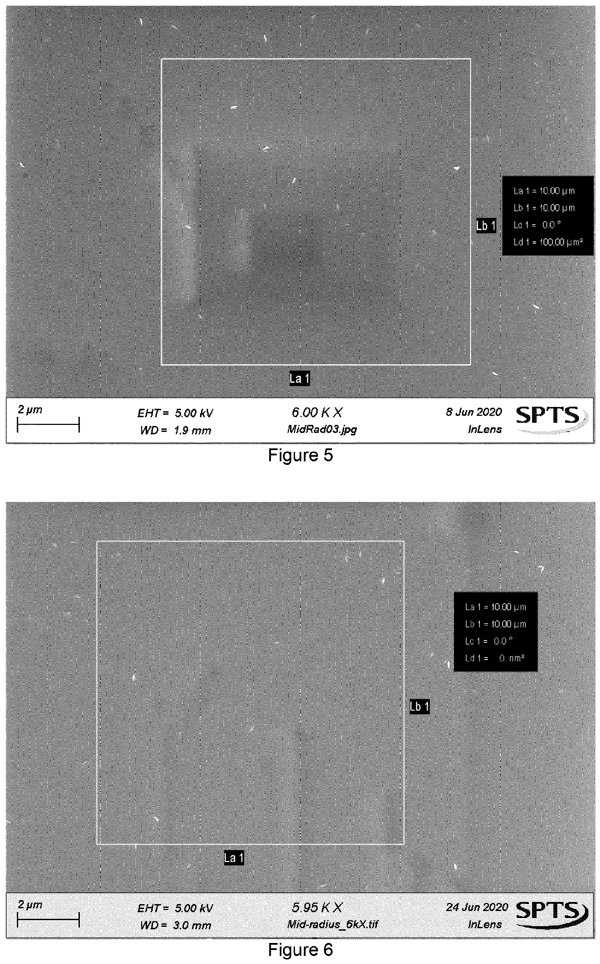

Figures 3, 4, 5, and 6 show SEM images of Al₇₀Sc₃₀N films deposited where the percentage of N₂ gas in the gaseous mixture was 100%, 83%, 67% and 36% respectively. The results are summarised in Table 2 below, and are shown graphically in Figure 7.

**Table 2**

| N₂ % of total flow | No. Defects per 100 µm² | 002 FWHM (°) |
|---|---|---|
| 100 | >>100 | 1.58 |
| 83 | >50 | 1.62 |
| 67 | <30 | 1.57 |
| 36 | <20 | 1.63 |

Figure 7 includes a plot of target voltage as a function of the percentage N₂ gas in the total gas flow. The transition point (i.e. poison threshold percentage) 72 occurred when the N₂ gas flow accounted for about 25% of the total gas flow rate. The transition point 72 can be determined due to a steep change in the target voltage (at constant target power). In this example, when the N₂ gas flow accounted for less than about 25% of the total gas flow, the apparatus was operating in a "metallic mode" 70. When the N₂ gas flow accounted for more than about 25% of the total gas flow, the target was fully poisoned and the apparatus was operating in a "poisoned mode" 74.

Changing the amount of N₂ gas (as a percentage of the total gas flow, in sccm) did not significantly affect the film texture. All Al₁₀₀₋ₓScₓN films exhibited good crystal orientation. However, unexpectedly, the defect density (i.e. no. of defects per 100 µm² as determined by analysing SEM images of the film) decreased as the amount of N₂ gas (as a percentage of the total gas flow, in sccm) was reduced.

Without wishing to be bound by any theory or conjecture, it is believed that at lower N₂ gas proportions, there is increased film bombardment due to the relatively higher proportion of the inert gas (i.e. Ar gas in this example). The inert gas acts as a non-reactive co-sputtering element, and the relatively higher proportions of the inert gas has the effect of increasing the amount of ion bombardment on the substrate surface. Again, without being bound by any theory or conjecture, it is believed that the increased film bombardment can be critical in film nucleation, and can help provide the template for crystal growth with good orientation. Still without being bound by any theory or conjecture, it is additionally believed that during film growth, the increased film bombardment can transfer sufficient energy to the additive element (e.g. relatively heavy Sc atoms in this example) to overcome energy barriers and move the additive element to a more favourable position within the crystal structure. Consequently, the number of misaligned grains, which are observed as crystallite defects, is reduced.

Again, without being bound by any theory or conjecture, it is also believed that a nitrogen-rich environment promotes the formation of different phases within the deposited film, which have different growth mechanics compared to the bulk material. These different phases appear as misaligned grains. However, reducing the relative proportion of nitrogen gas in the gaseous mixture moves the equilibrium away from forming these different phases.

Methods of the present invention can therefore be used to deposit high quality additive-containing aluminium nitride films with a high additive element content, whilst reducing the defect density to acceptable levels. Due to the improved defect density, the piezoelectric properties of the films are improved. The additive-containing aluminium nitride films produced using the present method are highly suited for use as a piezoelectric layer in piezoelectric devices, such as in bulk acoustic wave (BAW) devices.

## Claims

1. A method of sputter depositing from a target an additive-containing aluminium nitride film containing an additive element selected from: scandium (Sc), yttrium (Y), titanium (Ti), chromium (Cr), magnesium (Mg) and hafnium (Hf), the method comprising the steps of:
providing a semiconductor substrate having a metallic layer thereon in a chamber; and
depositing the additive-containing aluminium nitride film onto the metallic layer by pulsed DC reactive sputtering of the target;
wherein the step of depositing the additive-containing aluminium nitride film comprises introducing a gaseous mixture comprising nitrogen gas and an inert gas into the chamber at a flow rate in sccm, in which the flow rate of the gaseous mixture in sccm comprises a nitrogen gas flow rate in sccm, and in which the nitrogen gas flow rate in sccm is less than or equal to about 50% of the flow rate of the gaseous mixture in sccm and also is sufficient to fully poison the target.

2. A method according to claim 1, wherein the additive element is scandium or yttrium, preferably scandium.

3. A method according to claim 1 or 2, wherein the additive element, as an atomic percentage of the aluminium and additive element content of the additive-containing aluminium nitride film, is present in an amount in the range of 0.5 at.% to 40 at%, optionally in the range 8 at.% to 40 at.%, optionally in the range 10 at.% to 40 at.%, optionally in the range 12 at.% to 35 at.%, optionally in the range 15 at.% to 30 at.%, or optionally in the range 20 at.% to 25 at.%.

4. A method according to any previous claim, wherein the nitrogen gas flow rate in sccm is less than about 45%, optionally less than about 40%, optionally less than about 35%, and optionally about 30%, of the flow rate of the gaseous mixture in sccm.

5. A method according to any previous claim, wherein the nitrogen gas flow rate in sccm is greater than about 15%, optionally ≥20%, optionally ≥25%, or optionally ≥30%, of the flow rate of the gaseous mixture in sccm.

6. A method according to any previous claim, wherein the nitrogen gas flow rate in sccm used during the step of depositing the additive-containing aluminium nitride film is in the range of 25 to 250 sccm, optionally 30 to 200 sccm, optionally 40 to 150 sccm, optionally 45 to 100 sccm, or optionally about 50 sccm.

7. A method according to any previous claim, wherein the inert gas is argon, krypton, xenon or a mixture thereof.

8. A method according to any previous claim, wherein the additive-containing aluminium nitride film has a thickness of about 2 µm or less, optionally about 1.5 µm or less, optionally about 1 µm or less, or optionally about 0.5 µm or less.

9. A method according to any previous claim, wherein the additive-containing aluminium nitride film has a thickness of about 0.2 µm or greater, optionally about 0.3 µm or greater, or optionally about 0.5 µm or greater.

10. A method according to any previous claim, wherein the step of depositing the additive-containing aluminium nitride film comprises applying an electrical bias power to the substrate.

11. A method according to any previous claim, wherein the semiconductor substrate is a silicon wafer.

12. A method according to any previous claim, wherein the metallic layer is selected from: tungsten (W), molybdenum (Mo), aluminium (Al), platinum (Pt), and ruthenium (Ru).

13. A method according to any previous claim, further comprising a step of etching the metallic layer prior to the step of depositing the additive-containing aluminium nitride film.

14. A method according to any previous claim, further comprising the step of depositing a seed layer onto the metallic layer prior to the step of depositing the additive-containing aluminium nitride film so that the additive-containing aluminium nitride film is deposited onto the seed layer.

15. An additive-containing aluminium nitride film on a metallic layer of a semiconductor substrate produced using the method according to any of claims 1 to 14.
